# EUROPEAN PATENT SPECIFICATION

(11) **EP 3 302 985 B1**
(45) Date of publication and mention of the grant of the patent: **16.12.2020**
(21) Application number: 16734029.8
(22) Date of filing: 27.05.2016
(51) Int. Cl.: G03G 15/043, B41J 2/447, G03G 15/04, B41J 2/455, B41J 2/45, G03G 15/34

(54) **IMAGING DEVICE**
BILDGEBUNGSVORRICHTUNG
DISPOSITIF D'IMAGERIE

(30) Priority: 27.05.2015 GB 201509073; 27.05.2015 GB 201509077
(43) Date of publication of application: 11.04.2018
(73) Proprietor: Landa Labs (2012) Ltd., 7612301 Rehovot (IL)
(72) Inventor: RUBIN BEN HAIM, Nir, 4530380 Hod HaSharon (IL); NAGLER, Michael, 6949503 Tel Aviv (IL); LANDA, Benzion, 7405135 Nes Ziona (IL); KASHTI, Tamar, 7403758 Nes Ziona (IL); AKNIN, Ofer, 4938937 Petach Tikva (IL); YOGEV, Ronen, 7684200 Kibbutz Hulda (IL); TZUR, Itai, 7682900 Kibbutz Na'an (IL)
(74) Representative: Harrison IP Limited
(86) International application number: PCT/IB2016/053137
(87) International publication number: WO 2016/189510

(56) References cited:
- EP-A1- 2 036 734
- EP-A1- 2 481 597
- CN-A- 101 337 469
- US-A- 5 751 327
- US-A1- 2006 109 440
- US-A1- 2008 181 667
- US-A1- 2010 080 594
- US-B1- 6 469 728
- US-B2- 7 002 613

## Description

### FIELD

The present disclosure relates to an imaging device for projecting a plurality of individually controllable laser beams onto a surface that is movable relative to the imaging device. The imaging device will be described herein mainly by reference to its application in digital printing systems but its use is not limited to this application.

### BACKGROUND

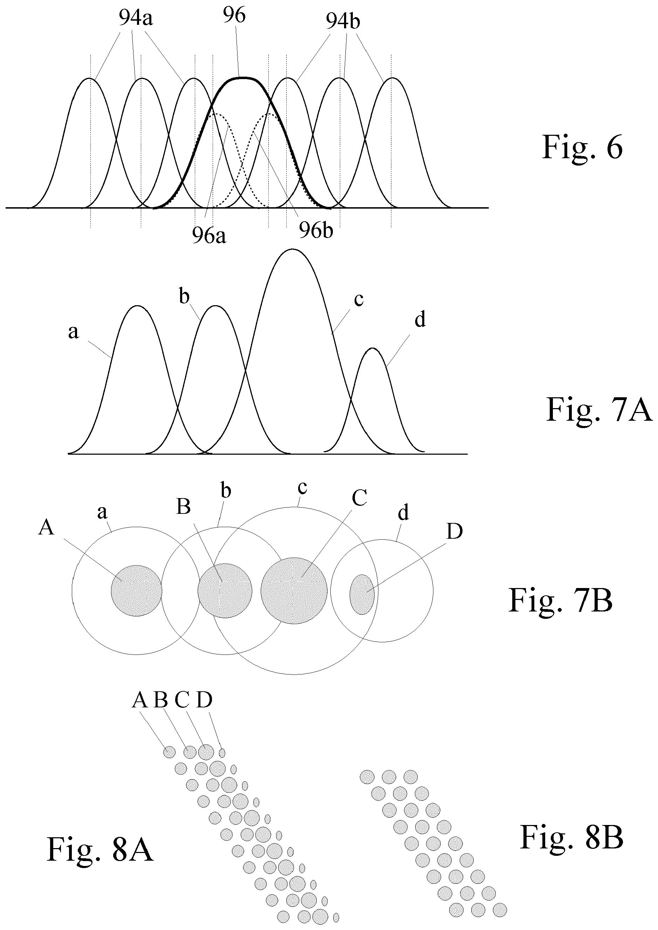

US 7,002,613 describes a digital printing system to which the imaging device of the present disclosure is applicable. In particular, in Figure 8 of the latter patent specification, there is shown an imaging device designated 84 that is believed to represent the closest prior art to the present disclosure. The imaging device serves to project a plurality of individually controllable laser beams onto a surface, herein termed an imaging surface, to generate an energy image onto that surface. The laser image can be used for a variety of purposes, just a few examples being to produce a two dimensional printed image on a substrate, as taught for instance in US 7,002,613, in 3D printing and in etching of an image onto any surface.

For high throughput applications, such as commercial printing or 3D lithography, the number of pixels to be imaged every second is very high, demanding parallelism in the imaging device. The laser imaging device of the present disclosure is intended for applications that require energy beams of high power. One cannot therefore merely scan the imaging surface with a single laser beam, so as to expose the pixels sequentially. Instead, the imaging device is required to have a separate laser emitting element for each pixel (picture element) of the image area of the imaging surface.

To achieve acceptable print quality, it is important to have as high a pixel density as possible. A high resolution image, for example one having 1200 dpi (dots per inch), requires a density of laser emitting elements that is not achievable if the laser emitting elements all lie in a straight line, due to the amount of overlap necessary between the laser sources to achieve a uniform printing quality. Aside from the fact that it is not physically possible to achieve such a high packing density, adjacent elements would interfere thermally with one another.

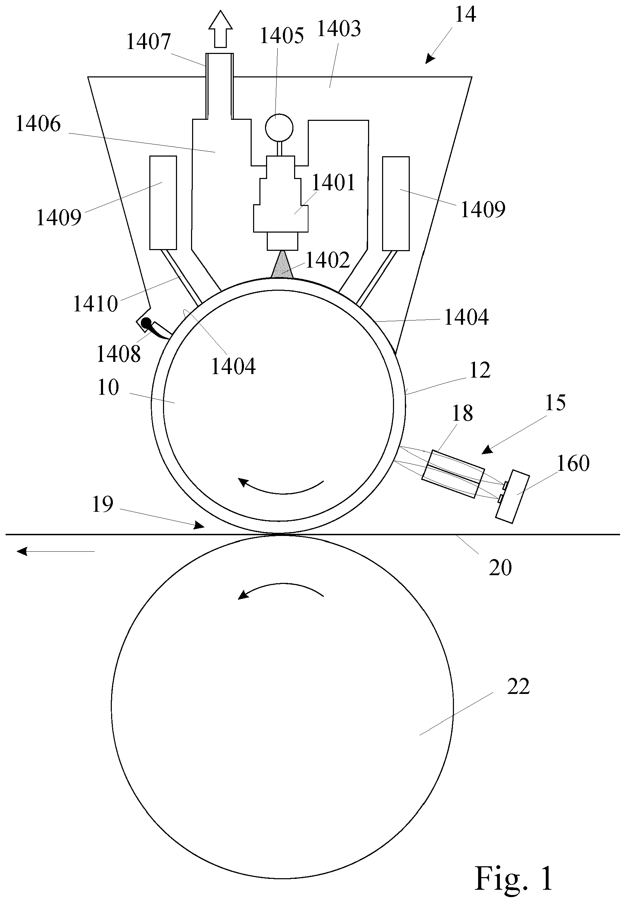

Semiconductor chips are known that emit beams of laser light in an array of M rows and N columns. In US 7,002,613 the rows and columns are exactly perpendicular to each other but the chips are mounted askew, in the manner shown in Figure 1 of the latter patent, so that each row can fill in the missing pixels of the preceding row(s). In this way, such an array can achieve a high resolution image but only over the width of the chip and such chips cannot simply be mounted side by side if one is to achieve a printed image without stripes along its length, because the chips cannot have laser emitting elements positioned sufficiently close to their lateral edges.

US 7,002,613 avoids this problem by arranging such chips in two rows, in the manner shown in Figure 8 of the latter patent. The chips in each row are staggered relative to the chips in the other row of the pair so that each chip in one row scans the gap left unscanned by the two adjacent chips in the other row.

Even though it is expected that the rows of chips will be mounted on a support under clean laboratory conditions using a microscope to achieve their correct alignment, it is not possible to guarantee that the relative alignment of the chips in the two rows will be accurate within the resolution of the printed image. Any misalignment will result in the image having stripes or other undesired defects.

US 2010/080594 and US 2008/181667 describe systems in which the light from arrays of LED's (rather than laser sources) is projected onto an image surface and teach how steps may be taken to compensate for any misalignment between the arrays. In each case, the images produced by adjacent arrays are overlapped and selected LED's from one or other of the two arrays are activated to maintain image continuity at the boundary between the two arrays. In the case of US 2010/080594 this overlap is shown clearly in Figure 14 and in US 2009/181667 it is evident, for example, from Figures 9A and 9B.

### SUMMARY

In the present disclosure, there is proposed an imaging device for projecting individually controllable laser beams onto an imaging surface that is movable relative thereto in a reference X-direction, the device including a plurality of semiconductor chips each of which comprises a plurality of individually controllable laser beam emitting elements arranged in a two dimensional main array of M rows and N columns, the elements in each row having a uniform spacing (Aᵣ) and the elements in each column having a uniform spacing (a_{c}), wherein the chips are mounted on a support in such a manner that each pair of chips that are adjacent one another in a reference Y-direction, transverse to the X-direction, are offset from one another in the X-direction, and, when activated continuously, the emitted laser beams of the two chips of said pair trace on the imaging surface 2•M•N parallel lines that extend in the X-direction and are substantially uniformly spaced in the Y-direction, the laser beams of each chip tracing a set of M•N lines that do not overlap the set of lines of the other chip, wherein in addition to the M rows and N columns of elements of the main array, each chip comprises at least one additional column on each side of the main array, each containing at least one selectively operable laser emitting element capable of compensating for any misalignment in the Y-direction in the relative positioning of the adjacent chips on the support by tracing at least one additional line that lies between the two sets of M•N lines.

Assuming that the M rows and N columns of laser emitting elements of the main array do not include any elements that are normally redundant, the spacing between adjacent lines in the set will be equal to Aᵣ/M, namely the spacing of the adjacent elements in each row divided by the number of rows. Furthermore, because in the present disclosure there is no overlap between the two sets of M•N lines traced by any two adjacent chips, the total number of lines traced by the two chips will be equal to 2•M•N, namely twice the product of the number of rows and the number of columns in each chip, if the chips have equal numbers of rows and columns.

In the present proposal, in addition to these evenly spaced lines produced by the main arrays, additional laser emitting elements are provided at both ends of each array intended only to compensate for chip misalignment. If adjacent chips are correctly aligned, the elements of the additional columns will be redundant and will not be energized. However, if a gap should remain between the lines traced by adjacent chips, the additional elements can introduce additional lines to fill that gap at a position approximating to the uniform spacing of the lines traced by the main arrays. It should be noted that, in contrast to the proposals in US 2010/080594 and US 2008/181667, the lines traced by the additional elements do not fall between (*i.e.* are not interlaced with) the lines of either set of M•N lines traced by the main arrays and only fall within any gap between the two sets of M•N lines.

In the event of an overlap between the two sets of M•N lines traced by the elements of adjacent chips, some of the elements of the main arrays can be switched off and if necessary replaced by an element of the additional columns to maintain the appearance of a raster with uniformly spaced lines.

On the other hand, if there is a gap between the two M•N lines traced by the elements of adjacent chips, the additional columns can be activated to maintain the appearance of a raster with uniformly spaced lines.

One of the additional elements may be activated on its own if its position coincides with a line that would render the raster uniform. Alternatively, if the elements have a symmetrical energy profile, resembling for example a Gaussian or a sinusoidal distribution, it is possible, by activating both elements to irradiate adjacent spots on the imaging surface and separately adjusting the power of each element, to produce a single raster line at an adjustable distance from the raster lines of the main elements of the two chips. It should be noted that this effect is thermally dynamic and additive provided that the adjacent spots are irradiated within a finite time of each other. In other words, the imaging surface should not have time to dissipate the energy of the first laser pulse in the interval between the two laser pulses.

Conveniently, the lines traced by elements in the same additional column are evenly spaced from one another, the spacing between the lines traced by the element of the additional column being substantially equal to the quotient of the spacing of the lines traced by the elements of main array and the number of elements in the additional column.

While it would be possible to use chips in which the rows and columns of the main arrays of laser emitting elements are perpendicular to one another, as taught in US 7,002,613, this requires the chips to be placed at an angle relative to the Y-direction. In some embodiments of the present disclosure the elements in each row of each chip lie on a line parallel to the Y-direction and the elements in each column of each chip lie on a straight line inclined at an angle to the X-direction. In other words, instead of the outline of the array being square, the array is shaped as a parallelogram. This arrangement, which may be considered slightly wasteful as far as chip area is concerned, can be advantageous in terms of assembling procedure.

It is convenient for the chips to be arranged in at least one pair of rows on the support, with corresponding laser emitting elements of all the chips in each of the two rows lying in line with one another in the Y-direction. By "corresponding elements" it is meant that the individual laser emitting elements should occupy the same row and column positions within their respective chips. It is advantageous for corresponding elements in any group of three chips in the pair of rows that are adjacent one another in the X and Y-directions to lie at the apices of congruent equilateral triangles. This simplifies the construction of a lens system that is needed to focus the laser beams onto the imaging surface.

It has been found particularly advantageous for all the laser beams emitted by one chip to be focused on the imaging surface by a common single lens, or a common set of lenses arranged in series, having a magnification of ±1. In other words, the image of the array of laser elements on the imaging surface (*i.e.* an array of dots) should have the same size as the array on the chip, though it may be inverted. In such a case even if there is a slight misalignment of the lenses, such as GRIN rod (Gradient-Index) lenses, in the XY plane perpendicular to the optical axis of the lens, the position of the illuminated laser spot on the imaging surface will remain unchanged, as it only depends on the position of the laser emitting element on the laser array chip. The former elements can be positioned with very high accuracy on every laser array chip using standard semiconductor manufacturing techniques.

While the lens system may comprise a single GRIN rod associated with each chip, it may alternatively comprise a plurality of GRIN rods arranged in series with one another and forming a folded light path. In the latter case, a prism common to all the chips may serve to direct the laser beams from one GRIN rod element to the next in each series.

In such a folded light path configuration, it is desirable for the prism to be made of a glass having a higher refractive index than the GRIN rods.

It is convenient for each chip to have in the main array an equal number of rows and columns of laser beam emitting elements (*i.e.,* M = N), as this minimizes the size of the lens array.

Within each chip, the separation between the laser elements should be sufficiently great to avoid thermal interference between adjacent laser emitting elements.

The support for the chip arrays may be fluid cooled to help dissipate the heat that may be generated by the chips.

Furthermore, the support may be a rigid metallic or ceramic structure and it may be formed of, or coated with, an electrically insulating surface bearing film conductors to supply electrical signals and power to the chips.

The chips in some embodiments are vertical cavity surface emitting laser (VCSEL) chip arrays.

In some embodiments, the intensity of the laser beam emitted by each element may be adjustable either continuously (in an analogue manner) or in discrete steps (digitally). In one embodiment, the chips may include D/A converters so as to receive digital control signals. In this way, the laser beam intensity may be adjusted in 4, 8, 16, 32 or up to 4096 discrete steps.

In a further aspect of the present disclosure, there is provided a method of projecting individually controllable laser beams onto an imaging surface that is movable relative to an imaging device utilising the imaging device of the present disclosure.

In some embodiments, at least one pair of laser elements, selected either both from the same array or one from each of two adjacent arrays, are controlled in such a manner that their energies are combined on the imaging surface to increase the temperature of the imaging surface above a predetermined threshold at a point intermediate the centers of the images of the two laser elements on the imaging surface, without raising the temperature of the imaging surface at at least one of the centers of the images of the two laser elements above the latter threshold.

### BRIEF DESCRIPTION OF THE DRAWINGS

Some embodiments of the imaging device are described herein with reference to the accompanying drawings. The description, together with the figures, makes apparent to a person having ordinary skill in the art how the teachings of the disclosure may be practiced, by way of non-limiting examples. The figures are for the purpose of illustrative discussion and no attempt is made to show structural details of an embodiment in more detail than is necessary for a fundamental understanding of the disclosure. For the sake of clarity and simplicity, some objects depicted in the figures are not to scale.

In the Figures:
Figure 1 is a schematic diagram of a digital printing system utilizing an imaging device according to an embodiment of the present disclosure;
Figure 2 shows part of an imaging device comprising a set of VCSEL chips mounted on a support;
Figure 3 is a schematic representation of the laser emitting elements of two VCSEL chips and the lines that they can trace on a relatively moving imaging surface;
Figure 4 is a schematic representation that demonstrates in one pair of rows the alignment between the VCSEL chips and the GRIN rods used as lenses to focus the emitted laser beams onto the imaging surface;
Figures 5A shows prior art proposals for correction of chip misalignment;
Figure 5B shows the manner in which the present disclosure compensates for chip misalignment;
Figure 6 shows the energy profiles produced by the laser elements at the ends of two adjacent arrays, to illustrate how a single line can be traced using two laterally positioned laser elements, there being shown for each array three elements of the main array and one of the additional elements;
Figure 7A is a similar energy diagram to Figure 6 to show how the energies of two adjacent laser elements of the main array can be combined on the imaging surface to produce an additional dot that does not fall on the center line of either of the laser elements;
Figure 7B shows the dot pattern on the imaging surface produced by activating four laser elements of the main array in the manner shown in Figure 7A;
Figure 8A shows how the dot pattern of Figure 7B assists in anti-aliasing;
Figure 8B shows for comparison with Figure 8A the jagged edge that normally occurs when printing an oblique line; and
Figure 9 shows an alternative lens system to that shown in Figure 1 that has a folded light path to permit more compact packaging in a printing system.

### DETAILED DESCRIPTION

### Overall description of an exemplary printing system

**Figure 1** shows a drum **10** having an outer surface **12** that serves as an imaging surface. As the drum rotates clockwise, as represented by an arrow, it passes beneath a coating station **14** where it acquires a monolayer coating of fine particles. After exiting the coating station **14,** the imaging surface **12** passes beneath an imaging device **15** of the present disclosure where selected regions of the imaging surface **12** are exposed to laser radiation which renders the particle coating on the selected regions of the surface **12** tacky. Next, the surface passes through an impression station **19** where a substrate **20** is compressed between the drum **10** and an impression cylinder **22.** This causes the selected regions of the coating on the imaging surface **12** that have been rendered tacky by exposure to laser radiation by the imaging device **15** in the correspondingly termed imaging station to transfer from the imaging surface **12** to the substrate **20.**

The term "tacky" as used herein is intended to mean that the irradiated particle coating is not necessarily tacky to the touch but only that it is softened sufficiently to be able to adhere to the surface of a substrate when pressed against it in the impression station **19.**

The regions on the imaging surface **12** corresponding to the selected tacky areas transferred to the substrate consequently become exposed, being depleted by the transfer of particles. The imaging surface can then complete its cycle by returning to the coating station **14** where a fresh monolayer particle coating is applied only to the exposed regions from which the previously applied particles were transferred to the substrate **20** in the impression station **19.**

In the present proposal, because the particles adhere to the imaging surface more strongly than they do to one another, the applied coating of particles, also interchangeably termed a particle layer or coating, is substantially a monolayer. While some overlap may occur between particles, the layer may be only one particle deep over a major proportion of the area of the surface and most, if not all, of the particles will have at least some direct contact with the imaging surface. Thus, the average thickness of the monolayer can be approximated by the average thickness of the individual particles forming it or, in some regions where particles overlap, by a low multiple of the dimension of the constituting particles, depending on the type and extent of the overlap. A monolayer may therefore have a maximum thickness (T) corresponding to up to about three times a thinnest dimension characteristic to the particles involved (*e.g*., the thickness of the particles for flake shaped ones or essentially the particle diameter for spherical ones).

The formation of a substantial monolayer mosaic of particles occurs for the same reason that an adhesive tape, when used to pick up a powder from a surface, will only pick up one layer of powder particles. When the adhesive tape is still fresh, the powder will stick to the adhesive until it covers the entire tape surface. However, once the adhesive has been covered with powder, the tape cannot be used to pick up any more powder because the powder particles will not stick strongly to one another and can simply be brushed off or blown away from the tape. Similarly, the monolayer herein is formed from the particles in sufficient contact with the imaging surface and is therefore typically a single particle thick. Contact is said to be sufficient when it allows the particle to remain attached to the imaging surface at the exit of the coating device.

Advantageously, a monolayer of particles facilitates the targeted delivery of radiation as emitted by the laser elements of an imaging device according to present teachings. This may ease the control of the imaging device and process, as the selectively irradiated particles reside on a single defined layer. When considered for use in a printing system, an imaging device targeting a monolayer can preferably focus the laser radiation to form upon transfer to a substrate a dot of approximately even thickness and/or relatively defined contour.

Another advantage of having a monolayer is that it can provide for good thermal coupling between the particles (e.g., polymers including pigments or dyes, for printing applications) and the imaging surface on which the particles are coated. As shall be described below, the imaging surface may be a heat absorbing substrate or made of a suitably heat absorbing material, thus easing the transfer of energy from the imaging surface to the polymer particle(s) which render them tacky. It should be mentioned that because of the very small thickness of the particles, most of the laser energy can pass through them without being absorbed. Instead of heating the particles directly, the laser radiation tends instead to heat the imaging surface and the particles are heated indirectly.

### The coating station

Reverting to the coating station **14,** it may comprise a plurality of spray heads **1401** that are aligned with each other along the axis of the drum **10** and only one is therefore seen in the section of Figure 1. The sprays **1402** of the spray heads are confined within a bell housing **1403,** of which the lower rim **1404** is shaped to conform closely to the imaging surface leaving only a narrow gap between the bell housing **1403** and the drum **10.** The spray heads **1401** are connected to a common supply rail **1405** which supplies to the spray heads **1401** a pressurized fluid carrier (gaseous or liquid) having suspended within it the fine particles to be used in coating the imaging surface **12.** In the present disclosure, the term "suspended in" and its variations is to be understood as "carried by" and like terms, not referring to any particular type of mixture of materials of same or different phase in any particular fluid, which may be optionally maintained at a desired controlled temperature.

If needed the suspended particles may be regularly or constantly mixed, in particular before their supply to the spray head(s). The particles may for instance be circulated in the coating apparatus within a flow rate range of 0.1 to 10 liter/minute, or in the range of 0.3 to 3 liter/min. The fluid and the surplus particles from the sprays heads **1401,** which are confined within a plenum **1406** formed by the inner space of the housing **1403,** are extracted through an outlet pipe **1407,** which is connected to a suitable suction source represented by an arrow, and can be recycled back to the spray heads **1401.** Though herein referred to as spray heads, any other type of nozzle or orifice along the common supply pipe or conduit allowing applying the fluid suspended particles are encompassed.

As an alternative to directly spraying of the particles and their carrier onto the imaging surface, it is possible for them to be sprayed onto an applicator, such as a rotating brush or sponge that then applies the particles to the imaging surface. For comprehensive coverage of the imaging surface, several such applicators may be contained in the coating station, which may have additional sponges for drying the imaging surface before it leaves the coating station.

It is important to be able to achieve an effective seal between the housing **1403** and the imaging surface **12,** in order to prevent the spray fluid and the fine particles from escaping through the narrow gap that must essentially remain between the housing **1403** and the imaging surface **12** of the drum **10.** Different ways of achieving such a seal are shown schematically in the drawing.

The simplest form of seal is a wiper blade **1408.** Such a seal makes physical contact with the imaging surface and could score the applied coating if used on the exit side of the housing **1403,** that is to say the side downstream of the spray heads **1401.** For this reason, if such a seal is used, it is preferred for it to be located only upstream of the spray heads **1401** and/or at the axial ends of the housing **1403.** The terms "upstream" and "downstream" as used herein are referenced to points on the imaging surface **12** as it cycles through the different stations.

Figure 1 also shows how egress of the fluid within which the particles are suspended from the sealing gap between the housing **1403** and the drum **10** can be prevented without a member contacting the imaging surface **12**. A gallery **1409** extending around the entire circumference of the housing **1403** is connected by a set of fine passages **1410** extending around the entire rim of the housing **1403** to establish fluid communication between the gallery **1409** and the sealing gap.

In a first embodiment, the gallery **1409** is connected to a suction source of a surplus extraction system, which may be the same suction source as is connected to the outlet **1407** or a different one. In this case, the gallery serves to extract fluid passing through the gap before it exits the housing **1403.** The low pressure also sucks off the drum **10** any particles that are not in direct contact with the imaging surface **12** and, if the sprayed fluid is a liquid, it also sucks off surplus liquid to at least partially dry the coating before it leaves the coating station **14.** Surplus liquid can alternatively and additionally be removed by mean of a liquid extracting roller (*e.g*., having a liquid absorbing surface) positioned on the exit side of the coating apparatus. Any such means of drying the particle coating (*e.g.,* a blower, a heater, a liquid extractor *etc*.), if present, can be internal to the coating device **14** (*i.e.,* within plenum **1406** of housing **1403),** or can alternatively be positioned downstream of the coating station, as long as it remains upstream of a station where the coating needs to be substantially dry. The drying element, if present, is advantageously compatible with the particle layer, and for instance does not negatively affect the particles and/or the integrity of the layer formed therefrom.

In an alternative embodiment, the gallery **1409** is connected to a source of gas at a pressure higher than the pressure in the plenum **1406.** Depending on the rate of fluid supply to the plenum through the spray heads **1401** and the rate of extraction through the outlet **1407,** the plenum **1406** may be at a pressure either above or below the ambient atmospheric pressure.

If the plenum is at sub-atmospheric pressure, then is suffices for the gallery **1409** to be at ambient pressure, or indeed no gallery need be present. In this case, because the pressure within the sealing gap will exceed the pressure in the plenum **1406,** gas flow through the gap will be towards the interior of the housing with no risk of fluid egress.

If the plenum is at above atmospheric pressure, then the gallery **1409** may be connected to a pressurized gas supply, preferably air. In this case, air will be forced into the sealing gap under pressure through the passages **1410** and will split into two streams. One stream will flow towards the plenum **1406** and will prevent egress of the fluid within which the particles are suspended. That stream will also dislodge and/or entrain particles not in direct contact with the imaging surface and assist in drying the coating if the carrier fluid is a liquid. The second stream will escape from the coating station without presenting a problem as it is only clean air without any suspended particles. The second gas stream may also assist in further drying of the particle coating on the imaging surface **12** before it leaves the coating station **14.** If desired, the gas stream can be heated to facilitate such drying.

In an alternative embodiment, the afore-mentioned gallery **1409** does not extend around the entire circumference of the housing, so as to seal the plenum **1406** on all sides. It can be a "partial" gallery or a combination of one or more air knives (with negative or positive flow) positioned either downstream or upstream of the spray heads in parallel to the axis of the drum and/or on the lateral edges of the spray heads in a direction perpendicular to the axis of the drum. A "partial" gallery on the exit side may, in some embodiments, serve as gas blower (*e.g.,* cold or hot air) additionally or alternatively facilitating the drying of the particles, in which case the passages **1410** may be adapted to provide sufficient flow rate.

In one embodiment, and independently of the type of fluid carrying the suspended particles being applied to the imaging surface, there is included on the exit side of the coating apparatus **14,** and typically at an external downstream location, a heater allowing the temperature of the particle layer and the imaging surface to be raised before it reaches the imaging station **160.** The temperature of the particles and the imaging surface may in this way be raised from ambient temperature to above 30°C, or 40°C or even 50°C, so as to reduce the amount of laser energy that is needed to render the particles tacky. However, the heating should not itself render the particles tacky and should not raise their temperature to above 80°C or possibly to above 70°C. Such heating of the particles and imaging surface may be further facilitated by using a fluid carrier at desired temperature.

In some embodiments, there can be included on the entry side of the coating apparatus **14,** and typically at an external upstream location, a cooler allowing lowering the temperature of the imaging surface before the particle layer is being replenished in the previously exposed regions. It is believed that an imaging surface at a temperature of less than 40°C, or less than 30°C, or even less than 20°C, but typically above 0°C, or even above 10°C, can reduce the temperature of the particles neighboring the exposed regions so that by the time the imaging surface is being replenished, the so cooled particles may have no or reduced "residual tackiness", that is to say a partial softening insufficient for a subsequent step (e.g., transfer to a printing substrate). The cooled coating behaves in the same manner as the particles freshly deposited on the exposed regions of the imaging surface. In this manner, only particles selectively targeted by any laser element of a chip of an imaging device as herein disclosed would become sufficiently tacky for a subsequent transfer step. Such cooling of the particles and imaging surface may be further facilitated by using a fluid carrier at desired temperature.

It is possible to provide both a cooler on the entry side of the coating apparatus **14** and a heater on the exit side, each cooler and heater operating as above described. Additionally, the drum **10** can be temperature controlled by suitable cooling / heating means internal to the drum, such temperature controlling means being operated, if present, in a manner to allow the outer surface of the imaging surface to be maintained at any desired temperature.

### The imaging surface

The imaging surface **12** in some embodiments is a hydrophobic surface, made typically of an elastomer that can be tailored to have properties as herein disclosed, generally prepared from a silicone-based material. The hydrophobicity assists in the separation of the particles from the imaging surface after they have been made tacky by exposure to radiation so at to allow the particles to transfer cleanly to the substrate without splitting.

A surface is said to be hydrophobic when the angle formed by the meniscus at the liquid/air/solid interface, also termed wetting angle or contact angle, exceeds 90°, the reference liquid being typically distilled water. Under such conditions, which are conventionally measured with a goniometer or a drop shape analyzer and can be assessed at a given temperature and pressure of relevance to the operational conditions of the coating process, the water tends to bead and does not wet, hence does not adhere, to the surface.

The imaging surface **12** may have any Shore hardness suitable to provide a strong bond to the particles when they are applied to the surface in the coating station **14,** the bond being stronger than the tendency of the particles to adhere to one another. The suitable hardness may depend on the thickness of the imaging surface and/or the particles intended to be bond. In some embodiments, a relatively high hardness between about 60 Shore A and about 80 Shore A is suitable for the imaging surface. In other embodiments, a medium-low hardness of less than 60, 50, 40, 30 or even 20 Shore A is satisfactory. In a particular embodiment, the imaging surface has a hardness of about 40 Shore A.

Advantageously, an imaging surface suitable for use with an imaging device herein disclosed can be flexible enough to be mounted on a drum, have sufficient abrasion resistance, be inert to the particles and/or fluids being employed, and/or be resistant to any operating condition of relevance (*e.g*., irradiation, pressure, heat, tension, and the like).

To be compatible with the radiation intermittently generated by the imaging station to expose desired selected areas, the imaging surface can, for instance, be relatively resistant and/or inert to the radiation, and/or able to absorb the radiation, and/or able to retain the heat generated by the radiation.

The imaging surface **12** in the drawing is the outer surface of a drum **10** but this is not essential as it may alternatively be the surface of an endless transfer member having the form of a belt guided over guide rollers and maintained under an appropriate tension at least while it is passing through the coating station.

### The particles

The particles may be made of any material and have any shapes and/or dimensions suitable to provide for sufficient contact area with the imaging surface, at least over a time period the particle coating is desired. Advantageously the material of the particles can be rendered sufficiently tacky by the laser elements so as to selectively transfer.

The shape and composition of the particles will depend in practice on the intended use of the layer of particles, and in the context of a non-limiting example of a printing system, on the nature of the effect to be applied to the surface of the substrate **20.** The particles may, for instance, comprise a thermoplastic polymer and optionally a coloring agent (*e.g.,* a pigment or a dye) and have a near spherical shape. The particles may further include a softening facilitating agent (*e.g.,* an IR absorbing dye) tuned to the wavelength emitted by the laser element, and preferably not affecting the desired color of the particle, having if necessary substantially no absorbance in the visible part of the spectrum. For printing of high quality, it is desirable for the particles to be as fine as possible to minimize the interstices between particles of the applied monolayer coating. The particle size is dependent upon the desired image resolution and for some applications a particle size (*e.g.,* a diameter) of 10 µm (micrometers) may prove adequate. However, for improved image quality, it is preferred for the particle size to be a few micrometers and more preferably less than about 1 µm. In some embodiments, suitable particles can have an average diameter between 100 nm and 4 µm, in particular between 500 nm and 1.5 µm.

Thus particle selection and ideal size determination, will depend upon the intended use of the particles, the effect sought (*e.g*., visual effect in the case of printing), and the operating conditions of the relevant system in which a coating device and imaging device according to the present teachings is to be integrated. Optimization of the parameters may be done empirically, by routine experimentation, by one of ordinary skill in the art.

Depending on their composition and/or on the processes they undergo, the particles can be hydrophobic with different degrees, if any, of hydrophilicity. As the balance between the hydrophobic and hydrophilic nature of the particles may shift with time, the process is expected to remain efficient if the hydrophobic nature of the particles predominates. Additionally, the particles may be made of materials intrinsically hydrophilic, in which case they can be rendered hydrophobic by application of a suitable particle coating.

The particles can be carried by either a gaseous or a liquid fluid when they are applied onto the imaging surface or upon the intermediate applicator(s). When the particles are suspended in a liquid, in order both to reduce cost and minimize environmental pollution, it is desirable for the liquid to be aqueous. In such a case, it is desirable for the polymer or material used to form or coat the particles to be hydrophobic. Hydrophobic particles more readily separate from an aqueous carrier, facilitating their tendency to attach to and coat the imaging surface. Such preferential affinity of the particles towards the surface of the coating device, rather than towards their carrier and towards one another, is deemed particularly advantageous. Blowing a gas stream over the particle coating (which as mentioned can preferably be formed by hydrophobic particles on an hydrophobic imaging surface) will both serve to dislodge particles not in direct contact with the imaging surface and to dry the particle coating on the imaging surface.

The above description is not intended to provide a comprehensive explanation of the operation of the entire digital printing system. Many details that are important for a successful implementation of such a printing system are not relevant to the present disclosure. However, the above description of the printing system of **Figure 1** is believed to be sufficient to enable the exemplary function that can be served by the imaging device of the present disclosure to be understood. It should, furthermore, be stressed that the imaging device is capable of being used for other purposes, for example selectively activating regions of an adhesive, etching a metal foil carried by the imaging surface or curing a polymer in a 3D printing system.

### The imaging device

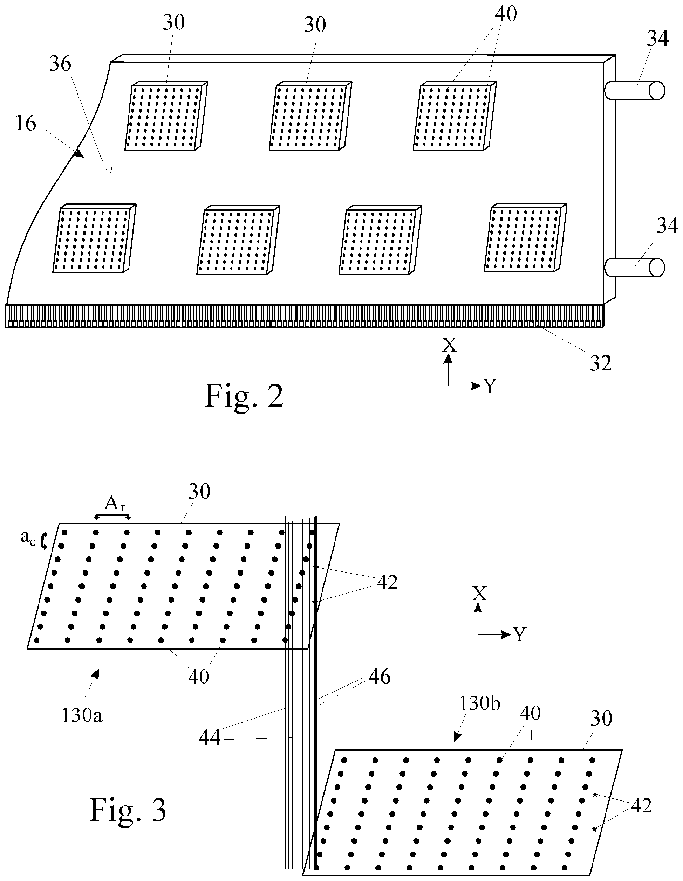

The imaging device **15** in **Figure 1** is composed of a support **16** carrying an array of laser sources such as VCSEL (vertical cavity surface emitting laser) chips that emit laser beams and an array of corresponding lenses **18** that focus the laser beams on the imaging surface **12.** **Figures 2** to **4** provide more details of the chips and the manner in which they are mounted on the support and aligned with the lenses **18.**

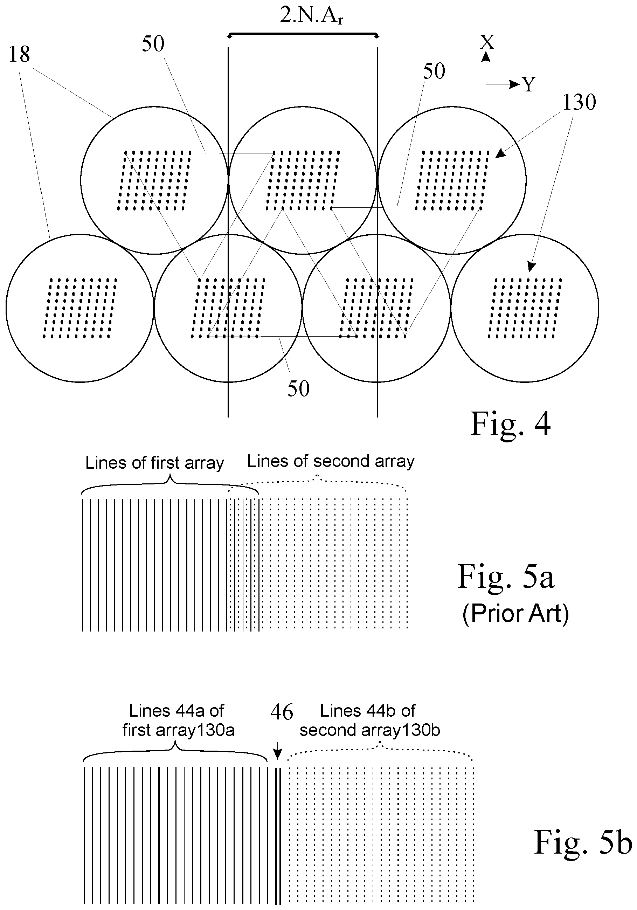

**Figure 2** shows the support **16** on which are mounted a plurality of VCSEL chips **30** arranged in two rows in accurately predetermined positions relative to one another, as will be described in more detail by reference to **Figures 3** and **4****.**

The support **16** is a rigid at least partially hollow elongate body fitted with connectors **34** to allow a cooling fluid to flow through its internal cavity. The body of the support may be made of an electrically insulating material, such as a suitable ceramic, or it may be made of a metal and at least its surface **36** on which the chips **30** are mounted may be coated with an electrical insulator. This enables a circuit board made of thin film conductors (not shown in the drawing) to be formed on the surface **36.** The chips **30** are soldered to contact pads on this circuit board and a connector **32** projecting from the lower edge of the support **16** allows control and power signals to be applied to the chips **30.** The laser emitting elements **40** of each chip **30** are individually addressable and are spaced apart sufficiently widely not to interfere thermally with one another.

In some embodiments, the individually controllable laser elements of a chip can emit laser beams having variable energy that is preferably digitally controllable in discrete steps, allowing the laser intensity to be set at any of 4, 8, 16 .... up to 4096 levels. The lowermost level of energy is defined as 0, where the individual laser element is not activated, the uppermost level of energy can be defined as 1. Such distinct levels may be considered analogous in the field of printing to "grey levels", each level providing for a gradually distinct intensity (*e.g*., shade when considering a colored output). Taking for instance, a laser beam emitting element having 16 levels of activation, level 0 would result in lack of impression (*e.g.,* leaving a substrate bare or white if originally so) and level 1 would result in transfer of a tacky film formed by a particle irradiated at maximum energy (*e.g*., forming a full black dot in the event the particles are so colored). In previous illustrative example, levels 1/16, 2/16, 3/16 and so on would correspond to increasingly stronger shades of grey, comprised between white (0) and black (1). Typically, the energy levels are evenly spaced.

In an alternative embodiment, the individually controllable laser elements of a chip can emit laser beams having variable energy that can be modulated in a continuous analogue manner.

Once a region of the imaging surface has reached a temperature at which the particles become tacky, any further increase in temperature will not have any effect on the transfer to the substrate. However, it should also be noted that as the intensity of the laser is increased the size of the dot that is rendered tacky also increases.

The energy profile of each dot resembles the plots shown in **Figure 6****,** that is to say that it is symmetrical with tapering sides. The exact profile is not important as the distribution may be Gaussian, sinusoidal or even an inverted V. In any such profile, as the peak intensity increases, the base widens and the area of intersection of the profile with a threshold at which the particle coating is rendered tacky also increases in diameter. A consequence of this energy distribution is that points of the imaging surface that are not in alignment with the centerline of any one laser emitting element will receive energy from adjacent elements. It is possible for two nearby elements to be energized to below the level needed to render coating particles on the centerline of the elements tacky, yet for the cumulative energy in the region of overlap between the two centerlines to rise above the level necessary to render the coating particles tacky. In this way, it is possible to create potential raster lines between the centerlines of the laser lines in addition to, or as an alternative to, the raster lines coinciding with the centerlines of the laser elements. This ability to combine the energies from adjacent elements is used to achieve different effect, as will be described below. These effects are dependent upon the ability of the imaging surface to combine energies received from different laser elements, even if there is a slight difference between the times of irradiation.

**Figure 3** shows schematically, and to a much enlarged scale, the relative positioning of two laser emitting element arrays **130a** and **130b** of VCSEL chips **30** that are adjacent one another in the Y-direction but are located in different rows. Each of the chips has a regular array of M by N laser emitting elements **40,** as previously described, that are represented by circular dots. In the example illustrated, M and N are equal, there being nine rows and nine columns. The spacing between the elements in a row, designated Aᵣ, and the spacing between the elements in a column, designate a_{c}, are shown as being different from one another but they may be the same. The array is shown as being slightly skewed so that the columns and rows are not perpendicular to one another. Instead, the rows lie parallel to the Y-direction while the columns are at a slight angle to the X-direction. This enables lines, such as the lines **44,** traced by the elements **40** on the imaging surface, if energized continuously, to be sufficiently close together to allow high resolution images to be printed. **Figure 3** shows that the element at the end of each row traces a line that is a distance Aᵣ/M away from the line traced by the corresponding element of each adjacent row, the separation between these lines being the image resolution Iᵣ. Thus Aᵣ and M are selected in dependence upon the desired image resolution, based on the equation Aᵣ = M x Iᵣ.

It should be mentioned that it is possible for the elements to lie in a square array where the columns are perpendicular to the rows. In this case, the chips would need to be mounted askew on their support and compensation would need to be applied to the timing of the control signals used to energize the individual elements.

As is clear from **Figure 3****,** and also **Figure 5B** which shows the traced lines to a larger scale, the positioning of the array **130b** is such that the line traced by its bottom left element **40** should ideally also be spaced from the line traced by the top right element of the array **130a** by a distance equal to Aᵣ/M. Therefore when all the elements **40** of both arrays **130a** and **130b** are energized, they will trace 2•M•N lines that will all be evenly spaced apart by a distance Aᵣ/M between adjacent lines, without any gaps.

If one wishes to provide compensation for defective elements, the array could include additional rows of laser emitting elements **40,** but it is alternatively possible to compensate for a defective element by increasing the intensity of the laser beams generated by the laser emitting elements that trace the two adjacent parallel lines.

In addition to the M by N array of elements **40,** each chip has two additional columns that are arranged one each side of the main array, each containing a respective further element **42.** These further elements **42** are represented in **Figure 3** by stars, to distinguish them from the main array elements **40.** The additional laser elements on each side of each array, can be positioned at a distance of 1/3 the spacing between traced lines that are imaged by the lenses onto the imaging surface. Furthermore additional elements could be placed in the gap between two arrays that nominally spans a distance of Aᵣ/M so that higher sensitivity is achieved in correcting the spacing errors between adjacent arrays.

As can be seen from **Figure 3** and **Figure 5B****,** when activated, these elements **42** trace two additional lines **46** between the two sets of evenly spaces parallel lines **44a and 44b** traced by the elements **40** of the two arrays **130a** and **130b,** respectively.

One of the additional lines **46** is spaced by a distance Aᵣ/3M from the last adjacent line **44a** traced, for example, by the array **130a** in Figure 3 and the other is spaced by a distance Aᵣ/3M from the first adjacent line **44b** traced, for example, by the array **130b.** In the event of a misalignment between the two arrays **130a** and **130b** these elements **42** can be energized in addition to, or instead of some of, the elements **40** of the main arrays to compensate for any misalignment between the arrays **130a** and **130b** that tends to create a stripe in the printed image, be it a gap or a dark line resulting from an overlap. **Figure 5A****,** which is similar to **Figure 5B****,** shows the alternative approach proposed in the prior art to compensate for chip misalignment. In the prior art, each chip has an additional row of elements that produces traced lines that are interlaced with the traced lines of the adjacent chip, resulting in a very high degree of redundancy.

While the two additional elements **42** in the present proposal are shown in **Figure 3** and **Figure 5B** as tracing two separate lines **46,** the energies of these two elements can be combined on the imaging surface, as earlier described, to form a single line of which the position is controllable by appropriate setting of the energies emitted by each of the additional elements **42.** This is shown in **Figures 6** in which the energy profiles of the lines **44a** and **44b** are designated **94a** and **94b,** respectively and the energy profiles of the additional lines **46** are designated **96a** and **96b.** In Figure 6, neither of the profiles **96a** and **96b** (shown in dotted lines) has sufficient energy to render the coating particles tacky but at the centerline between the two arrays the cumulative energy, shown as a solid dark line **96,** is sufficient to soften the particles coating and to create a trace line filling the gap between the trace lines **44a** and **44b** of the two main arrays.

While in Figure 6 the energy profiles of the two additional elements are matched, it is possible by varying the relative intensity of the two beams emitted by the additional laser sources to position the centerline of the combine energy at a different distance from the traces of the main arrays.

**Figure 7A** shows how the ability to create dots that do not fall on the centerlines of the energy profiles of the laser elements can be used to advantage to achieve anti-aliasing. **Figure 7A** shows the energy profiles of four adjacent elements of the main array. The first two profiles ***a*** and ***b*** are set at a desired level, say 8 (out of sixteen), corresponding to mid-grey. The energy profiles ***c*** and ***d*,** on the other hand are set to say 12 and 4, respectively. The resulting dot pattern produced on the imaging surface is shown in **Figure 7B****.** This can be seen to comprise two regular sized dots A and B aligned with the line of symmetry of the profiles ***a*** and ***b*** in Figure 7A, a larger sized dot C aligned with the centerline of energy profile ***c***, and a smaller dot D that lies somewhere between the centerlines of the profiles ***c*** and ***d***.

The result of repeating such a dot pattern diagonally is shown in **Figure 8A****.** When this image is compared with **Figure 8B****,** where no anti-aliasing steps have been taken, it will be seen that the small dots in between regular raster line yield oblique edges that have reduced jaggedness and produce an image that is comparable with one achievable by a printing system having a greater image resolution.

The interaction of energies from nearby laser elements can also be used to compensate for missing elements in that the elements producing the two adjacent raster lines can be used to combined in the same manner as previously explained to fill in a gap between them.

For the arrays **130a** and **130b** in **Figure 3** to function correctly as described above, their relative position in the Y-direction is critical. In order to simplify the construction of the lens system serving to focus the emitted laser beams on the imaging surface it is advantageous to adopt a configuration shown in **Figure 4** which enables the two rows of lenses corresponding to a pair of chip rows to be self-aligning.

**Figure 4** shows seven adjacent arrays **130** each shown lined up with a respective lens **18.** Though arrays **130** can as afore-mentioned include additional laser elements **42,** such are not shown on the present figure. Each lens **18** is constructed as a GRIN (Gradient-Index) rod, this being a known type of lens that is shaped as a cylinder having a radially graduated refractive index. In the case of the geometry shown in **Figure 4****,** corresponding elements of any three bi-directionally adjacent arrays **130** lie on the apices of an equilateral triangle, three such triangles designated **50** being shown in the drawing. It will be noted that all the triangles **50** are congruent. As a result, if the diameter of the GRIN rods is now selected to be equal to 2•N•Aᵣ, which is the length of the sides of the equilateral triangles **50,** or the distance between corresponding laser emitting elements of adjacent VCSEL chips **30** in the same row, then when stacked in their most compact configurations, the lenses **18** will automatically align correctly with their respective chip.

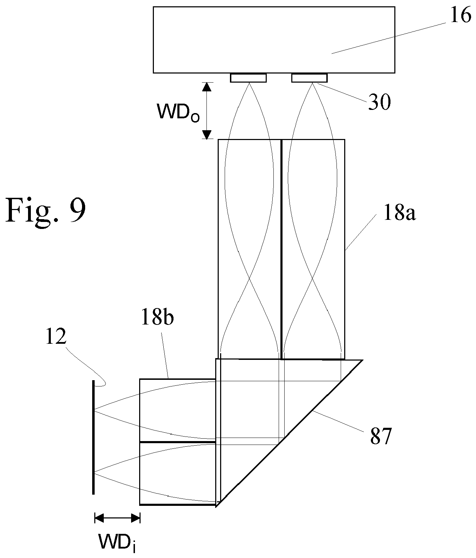

Though the lens **18** has been schematically illustrated in **Figure 1** (side view) and **Figure 4** (cross section view) as being an individual GRIN rod, in an alternative embodiment shown in **Figure 9** the laser beams of each chip can be transmitted by a series of lenses. In the case of **Figure 9****,** the single GRIN rod **18** is replaced by two mutually inclined GRIN rods **18a** and **18b** and the light from one is directed to the other by a prism **87** of high refractive index glass, so that the light follows a folded path. Such a configuration enables coating stations in a colour printing system to be arranged closer to one another in a more compact configuration. Such a folded light path can adopt different configurations while fulfilling all the requirements of magnification and light transmission. To enable the light path to be split in this manner, the length of the GRIN rods is selected such that light is collimated on leaving the rods **18a** and entering the rods **18b** as shown by the light rays drawn in **Figure 9****.**

The radiation guided by GRIN rod **18a,** the proximal end of which is arranged at a distance WDₒ from the chip, may be captured by the corresponding GRIN rod **18b** which can collect the collimated light emerging from rod **18a** on the same light path and focus it at a distance WDᵢ from the distal end of the second GRIN rod **18b.** When the two GRIN rods are made of the same material and the same radial gradient profile and WDₒ = WDᵢ a magnification of M=+1 can be obtained.

Laser elements that are away from the longitudinal axis of the GRIN rod **18a** will leave the distal end of the GRIN lens collimated but at an angle to the axis. In certain cases, it is necessary for the distance between the two rods **18a** and **18b** to be large, causing the off axis collimated beams exiting the first rod segment to miss partially or entirely the second segment. It is possible to take advantage of Snell's law and cause the beam exiting the first rod to travel through a glass with a high refractive index, thus causing the angle the collimated beam makes with the optical axis to decrease and enabling a larger separation between the rods before the collimated beams leaving the first rod miss the entrance to the second rod.

In the description and claims of the present disclosure, each of the verbs, "comprise" "include" and "have", and conjugates thereof, are used to indicate that the object or objects of the verb are not necessarily a complete listing of members, components, elements, steps or parts of the subject or subjects of the verb. These terms encompass the terms "consisting of' and "consisting essentially of'.

As used herein, the singular form "a", "an" and "the" include plural references and mean "at least one" or "one or more" unless the context clearly dictates otherwise.

Positional or motional terms such as "upper", "lower", "right", "left", "bottom", "below", "lowered", "low", "top", "above", "elevated", "high", "vertical", "horizontal", "backward", "forward", "upstream" and "downstream", as well as grammatical variations thereof, may be used herein for exemplary purposes only, to illustrate the relative positioning, placement or displacement of certain components, to indicate a first and a second component in present illustrations or to do both. Such terms do not necessarily indicate that, for example, a "bottom" component is below a "top" component, as such directions, components or both may be flipped, rotated, moved in space, placed in a diagonal orientation or position, placed horizontally or vertically, or similarly modified.

Unless otherwise stated, the use of the expression "and/or" between the last two members of a list of options for selection indicates that a selection of one or more of the listed options is appropriate and may be made.

In the disclosure, unless otherwise stated, adjectives such as "substantially" and "about" that modify a condition or relationship characteristic of a feature or features of an embodiment of the present technology, are to be understood to mean that the condition or characteristic is defined to within tolerances that are acceptable for operation of the embodiment for an application for which it is intended.

## Claims

1. An imaging device for projecting individually controllable laser beams onto an imaging surface that is movable relative thereto in a reference X-direction, the device including a plurality of semiconductor chips (30) each of which comprises a plurality of individually controllable laser beam emitting elements (40) arranged in a two dimensional main array of M rows and N columns, the elements in each row having a uniform spacing Aᵣ and the elements in each column having a uniform spacing a_{c}, wherein the chips are mounted on a support (16) in such a manner that each pair of chips that are adjacent one another in a reference Y-direction, transverse to the X-direction, are offset from one another in the X-direction, and, when activated continuously, the emitted laser beams of the two chips of said pair trace on the imaging surface 2•M•N parallel lines that extend in the X-direction and are substantially uniformly spaced in the Y-direction, the laser beams of each chip tracing a set of M x N lines that do not overlap the set of lines of the other chip, wherein in addition to the M rows and N columns of elements of the main array, each chip comprises at least one additional column on a side of the main array, each containing at least one selectively operable laser emitting element (42) capable of compensating for any misalignment in the Y-direction in the relative positioning of the adjacent chips on the support by tracing at least one additional line that lies between the two sets of M•N lines.

2. The imaging device as claimed in claim 1, wherein each additional column comprises two or more elements.

3. The imaging device as claimed in any one of the preceding claims, wherein the distance between the line traced by one of the additional laser emitting elements, and the adjacent line of the main array, is equal to the quotient of (i) the spacing of the lines traced by the elements of main array and (ii) a number greater by one than the number of elements in the additional columns.

4. The imaging device as claimed in any one of the preceding claims, wherein the elements in each row of each chip lie on a line parallel to the Y-direction and the elements in each column of each chip lie on a straight line inclined at an angle to the X-direction.

5. The imaging device as claimed in any one of the preceding claims, wherein the chips are arranged in pair of rows on the support, corresponding laser emitting elements of all the chips in each of the two rows lying in line with one another in the Y-direction.

6. The imaging device as claimed in claim 5, wherein the alignment of the chips within the two rows of the pair is such that corresponding elements in any group of three adjacent chips in the X and Y-directions lie at the apices of congruent equilateral triangles.

7. The imaging device as claimed in claim 6, wherein a respective lens is provided for each chip to focus the laser beams emitted by all the elements of the associated chip onto the imaging surface.

8. The imaging device as claimed in claim 7, wherein each lens is formed by a single GRIN rod.

9. The imaging device as claimed in claim 7, wherein each lens is formed by a series of two or more mutually inclined GRIN rods.

10. The imaging device as claimed in any one of claim 8 or 9, wherein the GRIN rods have a diameter equal to 2•N•Aᵣ, being the distance between corresponding elements of adjacent chips in each row.

11. The imaging device as claimed in any one of the preceding claims, wherein the support is fluid cooled.

12. The imaging device as claimed in any one of the preceding claims, wherein the support is constructed of a rigid metallic or ceramic structure, the surface of the support is formed of, or coated with, an electrical insulator bearing film conductors to supply electrical signals and power to the chips.

13. The imaging device as claimed in any one of the preceding claims, wherein the chips are vertical cavity surface emitting laser (VCSEL) chip arrays.

14. The imaging device as claimed in any one of the preceding claims, wherein each individually controllable laser beam element can emit a laser beam having 4 levels of energy or more, or 8 levels of energy or more, or 16 levels of energy or more, or even 32 levels of energy or more.

15. A method of projecting individually controllable laser beams onto an imaging surface that is movable relative to an imaging device utilising the imaging device according to any one of the preceding claims.

## Patentansprüche

1. Bildgebungsvorrichtung zum Projizieren individuell steuerbarer Laserstrahlen auf eine Bildgebungsoberfläche, die relativ dazu in einer Referenz-X-Richtung bewegt werden kann, wobei die Vorrichtung eine Vielzahl von Halbleiterchips (30) enthält, von denen jeder eine Vielzahl von individuell steuerbaren laserstrahlemittierenden Elementen (40) umfasst, die in einer zweidimensionalen Hauptanordnung aus M Reihen und N Spalten angeordnet sind, wobei die Elemente in jeder Reihe eine gleichförmige Beabstandung Ar aufweist und die Elemente in jeder Spalte eine gleichförmige Beabstandung Ac aufweisen, wobei die Chips auf einem Träger (16) so montiert sind, dass jedes Paar von Chips, die in einer Referenz-Y-Richtung, die quer zur X-Richtung ist, zueinander benachbart sind, in der X-Richtung versetzt zueinander sind, und, wenn sie kontinuierlich aktiviert sind, die emittierten Laserstrahlen der zwei Chips des Paars auf der Bildgebungsoberfläche 2•M•N parallele Linien nachverfolgen, die sich in der X-Richtung erstrecken und im Wesentlichen in der Y-Richtung gleichförmig beabstandet sind, wobei die Laserstrahlen jedes Chips einen Satz von M x N-Linien nachverfolgen, die den Satz der Linien des anderen Chips nicht überlappen, wobei zusätzlich zu den M Reihen und N Spalten von Elementen der Hauptanordnung jeder Chip mindestens eine zusätzliche Spalte auf einer Seite der Hauptanordnung umfasst, wobei jede mindestens ein selektiv bedienbares laseremittierende Element (42) enthält, das in der Lage ist, jegliche Fehlausrichtung in der Y-Richtung in der relativen Positionierung der benachbarten Chips auf dem Träger zu kompensiere, indem es mindestens eine zusätzliche Linie nachverfolgt, die zwischen zwei Sätzen von M•N-Linien liegt.

2. Bildgebungsvorrichtung nach Anspruch 1, wobei jede zusätzliche Spalte zwei oder mehr Elemente umfasst.

3. Bildgebungsvorrichtung nach einem der vorangehenden Ansprüche, wobei der Abstand zwischen der von einem der zusätzlichen laseremittierenden Elemente nachverfolgten Linie und der benachbarten Linie der Hauptanordnung gleich dem Quotienten aus (i) der Beabstandung der von den Elementen der Hauptanordnung nachverfolgten Linien und (ii) einer um eins größeren Zahl als die Anzahl der Elemente in den zusätzlichen Spalten ist.

4. Bildgebungsvorrichtung nach einem der vorangehenden Ansprüche, wobei die Elemente in jeder Reihe jedes Chips auf einer Linie parallel zur Y-Richtung liegen und die Elemente in jeder Spalte jedes Chips auf einer geraden Linie liegen, die in einem Winkel zur X-Richtung geneigt ist.

5. Bildgebungsvorrichtung nach einem der vorangehenden Ansprüche, wobei die Chips in Paar von Reihen auf dem Träger angeordnet sind, entsprechend den laseremittierenden Elementen aller Chips in jeder der zwei Reihen, die bündig miteinander in der Y-Richtung liegen.

6. Bildgebungsvorrichtung nach Anspruch 5, wobei die Ausrichtung der Chips in den zwei Reihen des Paars so ist, dass entsprechende Elemente in jeder Gruppe von drei benachbarten Chips in den X- und Y-Richtungen an den Scheitelpunkten kongruenter gleichseitiger Dreiecke liegen.

7. Bildgebungsvorrichtung nach Anspruch 6, wobei eine jeweilige Linse für jeden Chip bereitgestellt ist, um die von allen Elementen des zugeordneten Chips emittierten Laserstrahlen auf die Bildgebungsoberfläche zu fokussieren.

8. Bildgebungsvorrichtung nach Anspruch 7, wobei jede Linse durch eine einzelne GRIN-Stange geformt ist.

9. Bildgebungsvorrichtung nach Anspruch 7, wobei jede Linse durch eine Reihe von zwei oder mehreren geneigten GRIN-Stangen geformt ist.

10. Bildgebungsvorrichtung nach einem der Ansprüche 8 oder 9, wobei die GRIN-Stangen einen Durchmesser gleich 2•N•Ar aufweisen, wobei es sich um den Abstand zwischen entsprechenden Elementen benachbarter Chips in jeder Reihe handelt.

11. Bildgebungsvorrichtung nach einem der vorangehenden Ansprüche, wobei der Träger fluidgekühlt ist.

12. Bildgebungsvorrichtung nach einem der vorangehenden Ansprüche, wobei der Träger aus einer starren metallischen oder keramischen Struktur konstruiert ist, die Oberfläche des Trägers aus einem elektrischen Isolator geformt oder damit beschichtet ist, der Folienleiter trägt, um den Chips elektrische Signale und Energie zuzuführen.

13. Bildgebungsvorrichtung nach einem der vorangehenden Ansprüche, wobei die Chips VCSEL-(Vertical Cavity Surface Emitting Laser)-Chipanordnungen sind.

14. Bildgebungsvorrichtung nach einem der vorangehenden Ansprüche, wobei jedes individuell steuerbare Laserstrahlelement einen Laserstrahl mit 4 Energiepegeln oder mehr oder 8 Energiepegeln oder mehr oder 16 Energiepegeln oder mehr oder sogar 32 Energiepegeln oder mehr emittieren kann.

15. Verfahren zum Projizieren individuell steuerbarer Laserstrahlen auf eine Bildgebungsoberfläche, die relativ zu einer die Bildgebungsvorrichtung nach einem der vorangehenden Ansprüche nutzende Bildgebungsvorrichtung bewegt werden kann.

## Revendications

1. Dispositif d'imagerie destiné à projeter des faisceaux laser pouvant être commandés individuellement sur une surface d'imagerie qui est mobile par rapport à celui-ci dans une direction X de référence, le dispositif comprenant une pluralité de puces à semi-conducteurs (30) dont chacune comprend une pluralité d'éléments d'émission de faisceaux laser pouvant être commandés individuellement (40) agencés dans un réseau principal bidimensionnel de M rangées et N colonnes, les éléments dans chaque rangée possédant un espacement uniforme Ar et les éléments dans chaque colonne possédant un espacement uniforme ac, lesdites puces étant montées sur un support (16) d'une manière telle que chaque paire de puces qui sont adjacentes les unes aux autres dans une direction Y de référence, transversale à la direction X, soient décalées l'une de l'autre dans la direction X et, lorsqu'elles sont activées en continu, les faisceaux laser émis des deux puces de ladite paire tracent sur la surface d'imagerie 2•M•N lignes parallèles qui s'étendent dans la direction X et sont espacées de manière sensiblement uniforme dans la direction Y, les faisceaux laser de chaque puce traçant un ensemble de MxN lignes qui ne chevauchent pas l'ensemble des lignes de l'autre puce, en plus des M lignes et N colonnes d'éléments du réseau principal, chaque puce comprenant au moins une colonne supplémentaire sur un côté du réseau principal, chacune contenant au moins un élément d'émission laser (42) à fonctionnement sélectif capable de compenser tout désalignement dans la direction Y dans le positionnement relatif des puces adjacentes sur le support en traçant au moins une ligne supplémentaire qui se trouve entre les deux ensembles de M•N lignes.

2. Dispositif d'imagerie selon la revendication 1, chaque colonne supplémentaire comprenant deux éléments ou plus.

3. Dispositif d'imagerie selon l'une quelconque des revendications précédentes, ladite distance entre la ligne tracée par l'un des éléments d'émission laser supplémentaires et la ligne adjacente du réseau principal étant égale au quotient de (i) l'espacement des lignes tracées par les éléments du réseau principal et (ii) d'un nombre supérieur de un au nombre d'éléments dans les colonnes supplémentaires.

4. Dispositif d'imagerie selon l'une quelconque des revendications précédentes, lesdits éléments dans chaque rangée de chaque puce se trouvant sur une ligne parallèle à la direction Y et lesdits éléments dans chaque colonne de chaque puce se trouvant sur une ligne droite inclinée selon un angle par rapport à la direction X.

5. Dispositif d'imagerie selon l'une quelconque des revendications précédentes, lesdites puces étant agencées en paire de rangées sur le support, lesdits éléments d'émission laser correspondants de toutes les puces dans chacune des deux rangées étant alignés les unes avec les autres dans la direction Y.

6. Dispositif d'imagerie selon la revendication 5, ledit alignement des puces à l'intérieur des deux rangées de la paire étant de sorte que des éléments correspondants dans n'importe quel groupe de trois puces adjacentes dans les directions X et Y se trouvent aux sommets de triangles équilatéraux congruents.

7. Dispositif d'imagerie selon la revendication 6, une lentille respective étant prévue pour chaque puce pour focaliser les faisceaux laser émis par tous les éléments de la puce associée sur la surface d'imagerie.

8. Dispositif d'imagerie selon la revendication 7, chaque lentille étant formée par une seule tige à gradient d'index (GRIN).

9. Dispositif d'imagerie selon la revendication 7, chaque lentille étant formée par une série de deux tiges GRIN mutuellement inclinées ou plus.

10. Dispositif d'imagerie selon l'une quelconque des revendications 8 ou 9, lesdites tiges GRIN possédant un diamètre égal à 2•N•Ar, étant la distance entre des éléments correspondants de puces adjacentes dans chaque rangée.

11. Dispositif d'imagerie selon l'une quelconque des revendications précédentes, ledit support étant refroidi par fluide.

12. Dispositif d'imagerie selon l'une quelconque des revendications précédentes, ledit support étant constitué d'une structure métallique ou céramique rigide, ladite surface du support étant formée ou revêtue d'un isolant électrique portant des conducteurs en film pour fournir des signaux électriques et de l'énergie aux puces.

13. Dispositif d'imagerie selon l'une quelconque des revendications précédentes, lesdites puces étant des réseaux de puces à laser à cavité verticale émettant par la surface (VCSEL).

14. Dispositif d'imagerie selon l'une quelconque des revendications précédentes, chaque élément de faisceau laser pouvant être commandé individuellement pouvant émettre un faisceau laser possédant 4 niveaux d'énergie ou plus, ou 8 niveaux d'énergie ou plus, ou 16 niveaux d'énergie ou plus, ou même 32 niveaux d'énergie ou plus.

15. Procédé de proj ection de faisceaux laser pouvant être commandés individuellement sur une surface d'imagerie mobile par rapport à un dispositif d'imagerie utilisant le dispositif d'imagerie selon l'une quelconque des revendications précédentes.
